(19) Europäisches Patentamt / European Patent Office / Office européen des brevets

(11) **EP 2 515 335 B1**

## (12) FASCICULE DE BREVET EUROPEEN

(45) Date de publication et mention
de la délivrance du brevet:
**18.03.2015 Bulletin 2015/12**

(51) Int Cl.:
*H01L 27/146* (2006.01)  *H01L 27/148* (2006.01)
*H04N 13/02* (2006.01)

(21) Numéro de dépôt: **12161244.4**

(22) Date de dépôt: **26.03.2012**

(54) **Circuit integré imageur et dispositif de capture d'images stéréoscopiques**

Bildgebender integrierter Schaltkreis, und Vorrichtung zur Erfassung von Stereobildern

Imaging integrated circuit and device for capturing stereoscopic images

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **22.04.2011 FR 1153512**

(43) Date de publication de la demande:
**24.10.2012 Bulletin 2012/43**

(73) Titulaire: **Commissariat à l'Énergie Atomique
et aux Énergies Alternatives
75015 Paris (FR)**

(72) Inventeur: **Gidon, Pierre
38130 Echirolles (FR)**

(74) Mandataire: **Ilgart, Jean-Christophe
BREVALEX
95, rue d'Amsterdam
75378 Paris Cedex 8 (FR)**

(56) Documents cités:
WO-A2-00/50927     WO-A2-02/078324
US-A1- 2007 188 601     US-A1- 2009 219 432

**Description**

**DOMAINE TECHNIQUE**

L'invention concerne le domaine de la capture d'images stéréoscopiques fixes ou animées, à au moins deux vues.

L'invention s'applique notamment aux domaines de l'endoscopie, de la microscopie, de la photographie, des caméras vidéos (cinéma, contrôle industrielle, ...).

**ÉTAT DE LA TECHNIQUE ANTÉRIEURE**

Dans les domaines de la photographie et de la vidéo, la stéréoscopie, c'est-à-dire la reproduction d'une image, animée ou fixe, en relief à partir d'au moins deux images classiques, c'est-à-dire « planes », sans relief, est généralement réalisée par deux (ou plus) dispositifs de capture d'images, tels que des appareils photos ou caméras, orientés vers la même scène et permettant de capturer des images de cette même scène selon différents points de vue.

Plusieurs contraintes doivent être respectées par ces dispositifs :

- les images d'une même scène capturées selon différents points de vue doivent l'être simultanément,
- les dispositifs de capture doivent être identiques, à la dispersion technologique près,
- il faut pouvoir adapter la base stéréoscopique au sujet observé (la base stéréoscopique correspond à l'écart de position entre chaque paire de points de vue),
- il est nécessaire de pouvoir piloter la majorité des réglages des dispositifs simultanément,
- les réglages des dispositifs doivent être similaires : égalité des temps de pose, égalité des positions de netteté, égalité des diaphragmes des optiques, etc.

Des approximations sont nécessairement réalisées sur ces contraintes, les images stéréoscopiques résultantes souffrant donc généralement de ces approximations. Afin de réduire ces approximations, différentes solutions ont été proposées.

Il est par exemple connu de créer des images stéréoscopiques à partir d'une seule optique.

L'image est formée sur un seul circuit intégré imageur, ou capteur d'images, ce qui permet de supprimer les contraintes liées à l'égalité des réglages et des propriétés entre les différents dispositifs de capture.

Le document US 5 828 487 décrit notamment un dispositif de capture d'images stéréoscopiques comportant un obturateur disposé entre le système de lentilles du dispositif et le capteur d'images, permettant d'obturer alternativement un côté droit et un côté gauche du chemin optique et donc de capturer consécutivement deux images d'une même scène mais présentant chacune une perspective différente (images droite et gauche). Cette non-simultanéité des images capturées pose toutefois un problème lorsqu'un élément de la scène est en déplacement rapide car dans ce cas, la stéréoscopie est perdue, l'objet étant à deux positions différentes sur les images droite et gauche d'une même image stéréoscopique.

Il est également connu de réaliser un dispositif de capture d'images stéréoscopiques comportant deux systèmes optiques disposés l'un à côté de l'autre et formant deux images l'une à côté de l'autre sur un même circuit intégré imageur. Les contraintes sont dans ce cas très fortes sur les systèmes optiques. Un tel dispositif implique également de disposer une cloison entre les 2 moitiés du capteur, afin de former artificiellement deux capteurs l'un à côté de l'autre. De plus, par rapport à l'angle de champ initial du capteur, c'est-à-dire l'angle de champ du capteur lors d'une capture d'image non stéréoscopique, l'angle de champ du capteur d'images stéréoscopiques est dans ce cas réduit de moitié.

Il est également connu de réaliser un dispositif de capture d'images stéréoscopiques comportant un système de lentilles couplé à un système optique additionnel comprenant des miroirs permettant d'orienter les rayons lumineux d'une même scène sur deux circuits intégrés imageurs distants. Un tel dispositif a pour inconvénient de présenter un dé-synchronisme dans les images capturées et des différences de sensibilité entre les deux capteurs sont possibles car ces deux capteurs sont obtenus à partir de deux électroniques indépendantes. De plus, le système optique additionnel composé des miroirs est complexe et coûteux à réaliser.

**EXPOSÉ DE L'INVENTION**

Un but de la présente invention est de proposer un circuit intégré imageur permettant de réaliser une capture d'images stéréoscopiques s'affranchissant des contraintes devant être respectées par les dispositifs de l'art antérieur, pouvant être utilisé avec n'importe quel système optique, et notamment un unique système optique tel qu'un système optique classique de capture d'images non stéréoscopiques, dont l'angle de champ n'est pas réduit par rapport à un capteur d'images non stéréoscopiques, et ne posant pas de problème de synchronisme ou de simultanéité de capture des images.

Pour cela, la présente invention propose un circuit intégré imageur, également appelé capteur d'images, destiné à coopérer avec un système optique configuré pour diriger des rayons lumineux issus d'une scène vers une face d'entrée du circuit intégré imageur, le circuit intégré imageur étant configuré pour réaliser une capture stéréoscopique simultanée de *N* images correspondant à *N* vues distinctes de la scène, *N* étant un entier supérieur à 1, chacune des *N* images correspondant à des rayons lumineux dirigés par une portion du système optique différente de celles dirigeant les rayons lumineux correspondant aux *N-1* autres images, le circuit intégré imageur comportant :

- *N* sous-ensembles de pixels réalisés sur un même substrat, chacun des *N* sous-ensembles de pixels étant destiné à réaliser la capture d'une des *N* images qui lui est associée,
- des moyens interposés entre chacun des *N* sous-ensembles de pixels et la face d'entrée du circuit intégré imageur, et configurés pour, ou aptes à, laisser passer les rayons lumineux correspondant à l'image associée audit sous-ensemble de pixels et bloquer les autres rayons lumineux dirigés depuis le système optique vers ledit sous-ensemble de pixels,

et dans lequel lesdits moyens comportent :

- au moins deux couches opaques superposées l'une au-dessus de l'autre, disposées entre les pixels et la face d'entrée du circuit intégré imageur, les deux couches opaques étant traversées par une pluralité de trous formant, vis-à-vis de chaque pixel, au moins une paire de diaphragmes superposés aptes à laisser passer une partie des rayons lumineux correspondant à l'image associée au sous-ensemble de pixels dont fait partie ledit pixel et aptes à bloquer les autres rayons lumineux dirigés depuis le système optique vers ledit pixel et correspondant aux autres images, ou
- au moins deux niveaux de filtres colorés superposés l'un au-dessus de l'autre, disposés entre les pixels et la face d'entrée du circuit intégré imageur, et formant, vis-à-vis de chaque pixel, au moins une première paire de filtres colorés superposés configurés pour laisser passer une partie des rayons lumineux correspondant à l'image associée au sous-ensemble de pixels dont fait partie ledit pixel et au moins une deuxième paire de filtres colorés superposés configurés pour bloquer les autres rayons lumineux dirigés depuis le système optique vers ledit pixel et correspondant aux autres images.

Le circuit intégré imageur selon l'invention repose sur le principe optique selon lequel l'ensemble des rayons venant d'un même objet ou d'une même scène, dirigés par un unique système optique et reçus par le circuit intégré, correspondent à plusieurs ensembles de rayons formant des « vues » de l'objet ou de la scène sous différents angles. Ces différentes vues sont capturées simultanément par les différents sous-ensembles de pixels recevant chacun les rayons lumineux de la vue qui lui est associée.

La vision stéréoscopique est donc réalisée quand les différentes vues sont selon la direction du plan des pixels, correspondant a la direction liant les deux yeux de l'observateur final. Ainsi, les pixels des différents sous-ensembles de pixels peuvent être disposés de manière alternée selon un seul axe parallèle à la face d'entrée du circuit intégré imageur (par exemple un des axes X ou Y lorsque les pixels forment une matrice de côtés parallèles aux axes X et Y). Par exemple, lorsque le circuit intégré imageur est configuré pour réaliser une capture stéréoscopique simultanée de deux images, les pixels appartenant à l'un ou l'autre des deux sous-ensembles de pixels destinés à réaliser la capture des deux images sont disposés de manière alternée selon un seul axe parallèle à la face d'entrée du circuit intégré imageur.

Toutefois, il est possible que la répartition des pixels dans les différents sous-ensembles de pixels soit réalisée en alternant les pixels selon deux axes du capteur, ces axes étant parallèles à la face d'entrée du circuit intégré imageur et perpendiculaires l'un par rapport à l'autre (par exemple les axes X et Y d'une matrice de côtés parallèles aux axes X et Y). On obtient dans cette configuration un nombre plus important d'images capturées simultanément par le circuit intégré imageur, permettant, entre autre, de conserver une vision stéréoscopique malgré un basculement du capteur d'images ou de la direction d'observation, par sélection des images stéréoscopiques parmi l'ensemble des images capturées.

Le circuit intégré imageur selon l'invention a notamment pour avantage de pouvoir être utilisé avec un système optique classique de capture d'image, stéréoscopique ou non, tel qu'un objectif d'appareil photo ou un double périscope, et notamment avec un système optique dont l'élément de sortie dirigeant les rayons lumineux sur l'ensemble du circuit intégré imageur est une unique lentille. Toutes les images capturées sont issues d'un unique système optique. Le circuit intégré imageur selon l'invention est compatible avec de nombreux systèmes optiques tels que des lentilles ou des objectifs simples, des optiques périscopiques ou encore des systèmes catadioptriques.

Dans l'invention, le synchronisme de la capture des différentes images est assuré du fait qu'un seul capteur est utilisé pour la capture stéréoscopique. Ainsi, même si l'on souhaite profiter des avantages d'une longue pose par la lecture tournante des pixels (mode « rolling shutter »), du fait que les pixels capturant les deux (ou plus) images sont voisins, ils peuvent être lus simultanément avec la lecture d'une ligne du capteur.

Même si les pixels ne sont pas lus simultanément, mais juste l'un après l'autre, l'image stéréoscopique est toujours capturée avec le temps minimum possible, et cela pour un synchronisme maximum.

De plus, par rapport à un circuit intégré imageur non stéréoscopique de mêmes dimensions que le circuit intégré imageur selon l'invention, comportant le même nombre de pixels disposés de manière analogue mais ne comportant pas les moyens permettant la capture stéréoscopique des images, le champ de vision du couple système optique - circuit intégré imageur n'est pas modifié.

La base stéréoscopique est choisie par construction, et n'est pas limitée par le capteur. C'est l'optique qui décide de cette base stéréoscopique.

Dans la zone de profondeur de champ de l'optique, l'information de parallaxe est plus précise que le flou minimum de l'image (tache d'Airy).

De plus, un problème classique en stéréoscopie et connu sous le nom de « violation de la fenêtre stéréoscopique » est facile à résoudre par un recadrage *a posteriori* des différentes images capturées. Ce problème concerne l'image en relief des bords des N images. En effet, ces bords sont vus comme un cadre plan dans l'image finale. Or, l'image finale est vue en relief, c'est-à-dire comme un volume. Des avant-plans de ce volume peuvent se trouver devant le cadre plan. Le problème est que ce cadre positionné souvent en arrière masque alors un avant-plan, ce qui rend l'image incompréhensible car c'est un état inexistant dans le monde réel. Le cadre par défaut des images capturées par le circuit intégré imageur se trouve autour du plan de netteté maximal. Les avant-plans se trouvent donc en général devant le plan de netteté maximal. Une solution avantageuse à ce problème permettant de déplacer (avancer) la position du cadre dans l'image en relief peut donc consister à recadrer les N images *a posteriori* (après la capture). Une autre solution pourrait consister, dans le cas de deux images capturées, à masquer par construction des pixels d'un premier bord de l'image pour l'une des images et à masquer les pixels d'un second bord opposé de l'image pour l'autre image.

Le circuit intégré imageur selon l'invention peut être réalisé aussi bien en technologie CMOS qu'en technologie CCD.

Bien que l'invention soit ici décrite pour le domaine des longueurs d'ondes du domaine visible, l'invention peut s'appliquer aux domaines des ultraviolets et/ou de l'infrarouge.

Par rapport à un capteur d'images stéréoscopiques faisant appel à des microlentilles pour diriger les rayons lumineux vers les pixels appropriés, la réalisation et le contrôle des caractéristiques desdits moyens exposés ci-dessus sont plus aisés que pour des microlentilles dont la forme doit être très précisément contrôlée. De plus, l'épaisseur des micro-lentilles induit également un effet de réfraction. La correction de cet effet de réfraction demande alors de maîtriser le pas et la courbure des lentilles, alors que pour des filtres colorés ou des couches opaques, seule la position des ouvertures doit être maîtrisée.

De plus, l'utilisation de lentilles recouvrant chacune 4 pixels nécessite de réaliser une reconstruction stéréoscopique complexe à partir de 4 images.

Dans un premier mode de réalisation, lesdits moyens peuvent comporter au moins deux couches opaques superposées l'une au-dessus de l'autre, disposées entre les pixels et la face d'entrée du circuit intégré imageur, les deux couches opaques étant traversées par une pluralité de trous formant, vis-à-vis de chaque pixel, au moins une paire de diaphragmes superposés aptes à laisser passer une partie des rayons lumineux correspondant à l'image associée au sous-ensemble de pixels dont fait partie ledit pixel et aptes à bloquer les autres rayons lumineux dirigés depuis le système optique vers ledit pixel et correspondant aux autres images.

Dans une première variante, le nombre de trous traversant chacune des deux couches opaques peut être égal au nombre total de pixels des $N$ sous-ensembles de pixels.

Lorsque N = 2 et que ladite portion du système optique correspond à une moitié du système optique (c'est-à-dire m = 2), une distance $H$ entre les pixels et une seconde des deux couches opaques, une première des deux couches opaques étant disposée entre les pixels et la seconde des deux couches opaques, peut être telle que $H \leq 1,5.pO.n,$ avec :

$p$ : pas des pixels,
$O$ : ouverture numérique du système optique,
$n$ : indice optique d'un matériau transparent disposé entre les deux couches opaques.

Dans une deuxième variante, le nombre de trous traversant une première des deux couches opaques peut être égal au nombre total de pixels des $N$ sous-ensembles de pixels, et le nombre de trous traversant une seconde des deux couches opaques peut être égal à $(M_{pix}/N) \pm 1,$ avec $M_{pix}$ correspondant au dit nombre total de pixels, ladite première des deux couches opaques pouvant être disposée entre les pixels et la seconde des deux couches opaques.

Une distance $H$ entre les pixels et la seconde des deux couches opaques peut être telle que

$$H = \frac{n.m.O.(N-1).p}{(m-1)+(m/D).(N-1).p} \text{ , avec :}$$

D : diamètre du système optique,
D/m : diamètre d'une desdites portions du système optique,
p : pas des pixels,
O : ouverture numérique du système optique,
n : indice optique d'un matériau transparent disposé entre les deux couches opaques.

Dans ce cas, lorsque N = m et que le diamètre du système optique est très grand devant les pas des pixel, une distance *H* entre les pixels et la seconde des deux couches opaques peut être telle que *H = N.p.O.n.*

Au moins l'une des couches opaques peut être formée par des lignes d'interconnexions électriques reliées électriquement aux pixels. Une telle configuration a notamment pour avantage d'utiliser les couches d'interconnexions électriques, présentes dans tous les circuits intégrés imageurs, et ne nécessite donc pas la réalisation de couches opaques supplémentaires. De plus, l'utilisation des interconnexions électriques pour former lesdits moyens permet de ne pas ajouter d'éléments supplémentaires obturant la lumière, ce qui permet de ne pas réduire la quantité de lumière arrivant sur la face d'entrée du circuit intégré imageur.

Les pixels peuvent être disposés entre la face d'entrée du circuit intégré imageur et des lignes d'interconnexions électriques reliées électriquement aux pixels. Le circuit intégré imageur est dans ce cas de type « Back-side ».

Les trous formés dans les couches opaques peuvent former des tranchées alignées les unes à côté des autres. Les trous peuvent être disposés en quinconce, et former ainsi un « damier ». Une telle disposition en quinconce permet de réduire les effets de moiré sur les images capturées. Une telle disposition en quinconce serait très difficilement réalisable avec des microlentilles cylindriques en raison du plan très difficile à réaliser aux extrémités de la direction linéaire des microlentilles cylindriques par exemple alignées au-dessus de colonnes de pixels.

Chaque pixel peut comporter des éléments électriques et/ou électroniques non photosensibles masqués par les couches opaques. Cette configuration est avantageuse car on utilise les zones ne pouvant pas être atteintes par les rayons lumineux pour y disposer les éléments ne formant pas les éléments photosensibles des pixels.

Les deux couches opaques peuvent être espacées l'une de l'autre par de l'air et/ou du SiO$_2$ et/ou une résine (ou un autre matériau) optiquement transparente aux rayons lumineux destinés à être capturés par les pixels.

Les deux couches opaques peuvent être composées de métal et/ou de résine et/ou recouvertes d'au moins une couche antireflet.

Dans un second mode de réalisation, lesdits moyens peuvent comporter au moins deux niveaux de filtres colorés superposés l'un au-dessus de l'autre, disposés entre les pixels et la face d'entrée du circuit intégré imageur, et peuvent former, vis-à-vis de chaque pixel, au moins une première paire de filtres colorés superposés configurés pour laisser passer une partie des rayons lumineux correspondant à l'image associée au sous-ensemble de pixels dont fait partie ledit pixel et au moins une deuxième paire de filtres colorés superposés configurés pour bloquer les autres rayons lumineux dirigés depuis le système optique vers ledit pixel et correspondant aux autres images. Ce mode de réalisation utilise avantageusement les filtres colorés présents dans un capteur d'images couleur pour réaliser les moyens permettant la capture d'images stéréoscopiques, notamment pour des capteurs d'images « back-side » dans lesquels les rayons lumineux ne traversent pas les lignes d'interconnexions métalliques du capteur. Là encore, on n'ajoute pas d'éléments d'obturation supplémentaires qui réduiraient la quantité de lumière capturée par le circuit intégré imageur.

Au moins un des deux niveaux de filtres colorés peut comporter également des portions de matériau opaque configurés pour bloquer, vis-à-vis de chaque pixel, une partie desdits autres rayons lumineux dirigés depuis le système optique vers ledit pixel et correspondant aux autres images.

Les deux niveaux de filtres colorés peuvent être espacées l'un de l'autre par de l'air et/ou du SiO$_2$ et/ou une résine (ou un autre matériau) optiquement transparente aux rayons lumineux destinés à être capturés par les pixels.

Les pixels peuvent être configurés pour capturer des images dans le domaine visible et/ou infrarouge.

L'invention concerne également un dispositif de capture d'images stéréoscopiques comportant au moins un circuit intégré imageur tel que décrit précédemment et au moins un système optique configuré pour diriger des rayons lumineux issus d'une scène vers le circuit intégré imageur.

Les pixels du circuit intégré imageur peuvent être configurés pour capturer des images dans le domaine infrarouge, ledit dispositif pouvant être un bolomètre.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- les figures 1 à 4 représentent un dispositif de capture d'images comportant un circuit intégré imageur, objet de la présente invention, selon différentes variantes d'un premier mode de réalisation,
- la figure 5 représente un dispositif de capture d'images comportant un circuit intégré imageur, objet de la présente invention, selon un deuxième mode de réalisation,
- les figures 6 à 8 représentent différentes variantes de réalisation d'un dispositif de capture d'images comportant un circuit intégré imageur, objet de la présente invention,
- la figure 9 représente les dimensions des éléments d'un dispositif de capture d'images comportant un circuit intégré imageur, objet de la présente invention,
- les figures 10A et 10B illustrent des règles de construction respectées lors de la conception d'un dispositif de capture d'images comportant un circuit intégré imageur, objet de la présente invention,
- la figure 11 représente la réfraction subie par un rayon lumineux dans un dispositif de capture d'images comportant un circuit intégré imageur, objet de la présente invention,
- la figure 12 représente un exemple de motif formé par des trous réalisés dans une couche opaque d'un circuit intégré imageur, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

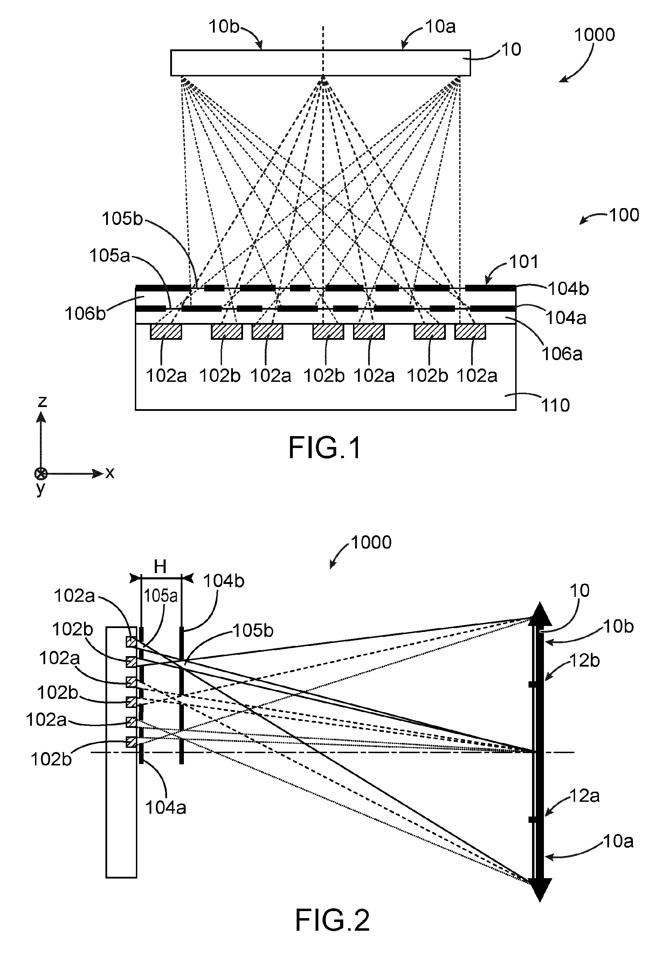

On se réfère tout d'abord à la figure 1 qui représente un dispositif de capture d'images 1000 comportant un circuit intégré imageur, ou capteur d'images, 100 selon un premier mode de réalisation.

Dans ce premier mode de réalisation, le dispositif 1000 permet de réaliser une capture d'images stéréoscopiques à deux images, ou deux vues, et correspond par exemple à un appareil photo ou une caméra. Le dispositif 1000 comporte également d'autres éléments, et notamment un système optique 10 comprenant au moins une ou plusieurs lentilles et correspondant par exemple à un objectif photographique à focal fixe.

Le circuit intégré imageur 100, appelé par la suite capteur d'images, comporte une pluralité de pixels 102 comportant chacun au moins un photodétecteur, par exemple une photodiode ou tout autre moyen équivalent permettant de transformer une information optique reçue (quantité de photons) en un signal électrique. Les rayons lumineux dirigés par le système optique 10 et arrivant sur le capteur d'images 100 au niveau d'une face d'entrée 101 correspondent aux images destinées à être capturées par le capteur d'images 100. Un premier sous-ensemble de pixels référencés 102a est destiné à capturer une première partie des rayons lumineux dirigés vers le capteur d'images 100. Un second sous-ensemble de pixels référencés 102b est destiné à capturer une seconde partie des rayons lumineux dirigés vers le capteur d'images 100. Sur l'exemple de la figure 1, les pixels 102a et 102b sont disposés de manière alternée les uns à côté des autres parallèlement à l'axe x. Dans cet exemple, cette alternance des pixels appartenant à l'un ou l'autre des sous-ensembles de pixels est uniquement réalisée selon l'axe X (et non selon l'axe y).

Afin de sélectionner les rayons devant être capturés par l'un ou l'autre des sous-ensembles de pixels 102a, 102b, le capteur d'images 100 est muni d'un masque formé de deux couches opaques 104a, 104b, c'est-à-dire non transparentes vis-à-vis des rayons lumineux reçus par le capteur d'images 100, superposées et interposées entre les pixels 102 et le système optique 10. Ces couches opaques 104a, 104b sont par exemple à base de métal. Chacune des couches opaques 104a, 104b comporte plusieurs ouvertures 105a, 105b, ou trous, telles que, pour chaque pixel, chaque couche opaque forme un diaphragme. Ainsi, pour chaque pixel, une des ouvertures 105a formées dans la couche 104a forme un diaphragme inférieur sur lequel est superposé un diaphragme supérieur formé par une des ouvertures 105b réalisées dans la couche 104b.

Sur l'exemple représenté sur la figure 1, chacune des couches 104a, 104b comporte un nombre d'ouvertures 105a, 105b correspondant au nombre total de pixels 102a, 102b du capteur d'images 100. Dans l'exemple décrit ici où le capteur d'images 100 est destiné à réaliser une capture d'images stéréoscopiques à deux images ou deux vues, les photodétecteurs des pixels 102a ne reçoivent que les rayons lumineux provenant de la moitié droite (référencée 10a sur la figure 1) du système optique 10, les photodétecteurs 102b ne recevant que les rayons provenant de la moitié gauche (référencée 10b sur la figure 1) du système optique 10. Les rayons provenant du milieu du système optique 10 sont reçus par tous les pixels 102a et 102b.

Les rayons provenant de la moitié droite 10a du système optique 10 n'atteignent pas les pixels 102b du fait qu'ils sont bloqués par l'une et/ou l'autre des couches opaques 104a, 104b. De même, les rayons lumineux provenant de la moitié gauche 10b du système optique 10 n'atteignent pas les pixels 102a du fait qu'ils sont bloqués par l'une et/ou l'autre des couches opaques 104a, 104b.

Une première image est donc obtenue à partir des signaux délivrés par les pixels 102a et une seconde image est obtenue à partir des signaux délivrés par les pixels 102b. Les rayons lumineux dirigés par l'une des moitiés 10a,10b de l'optique 10 arrivent dans un pixel sur deux du capteur d'images 100 alors que ceux provenant de l'autre moitié sont arrêtés par les diaphragmes pour ces mêmes pixels, mais atteignent les autres pixels, inaccessibles aux rayons de la première moitié en raison de la présence des diaphragmes.

Les indices optiques des matériaux utilisés sont choisis tels que la réfraction dans les matériaux a un impact très faible vis-à-vis de la taille et la position des ouvertures 105a, 105b formées dans les couches opaques 104a, 104b.

Les pixels 102 du capteur d'images 100 peuvent être espacés les uns des autres d'un pas régulier ou non. La maximisation du nombre de pixels dans un capteur d'images est généralement obtenue en espaçant les pixels d'un pas régulier, la zone ombrée entre deux photodétecteurs étant égale à la largeur d'un photodétecteur dans le cas d'une capture stéréoscopique à deux images. Pour chaque pixel, les éléments autres que le photodétecteur (lignes d'interconnexion, transistors, ...) sont avantageusement disposés en regard des parties opaques des couches 104a, 104b.

Sur l'exemple de la figure 1, la première couche opaque 104a est disposée sur une première couche transparente 106a, par exemple à base d'un matériau diélectrique, recouvrant les photodétecteurs 102. De même, la deuxième couche opaque 104b est disposée sur une deuxième couche transparente 106b, par exemple à base d'un matériau diélectrique, recouvrant la première couche opaque 104a.

Les couches opaques 104a, 104b sont relativement proches des pixels 102. Dans le capteur d'images 100, les couches opaques 104a et 104b comportent un même nombre de trous 105a, 105b. De plus, le diamètre de l'optique 10 est très supérieur au pas entre deux pixels. Pour le capteur d'images 100, la distance $H$ entre la couche opaque 104b, formant les diaphragmes supérieurs, et les pixels 102 peut être inférieure ou égale à environ $1,5.p.O.n,$ avec :

$p$ : pas entre deux pixels,
N : nombre de vues capturées (ici N = m = 2),
$O$ : ouverture numérique de l'optique 10 (égale au rapport de la focale F sur le diamètre D),
$n$ : indice optique du matériau transparent des couches 106a, 106b.

Dans une variante avantageuse, la deuxième couche opaque 104b formant les diaphragmes supérieurs peut être disposée à une distance particulière des pixels 102, cette distance étant approximativement égale à $2.p.O.n$ lorsque le pas des pixels est très petit devant le diamètre $D$ de l'optique 10, que N=2 et que la surface du matériau dans les ouvertures des diaphragmes est plane. Dans ce cas, le nombre d'ouvertures formées dans la deuxième couche opaque 104b, formant les diaphragmes supérieures, est égal à la moitié du nombre de pixels, plus ou moins un. Un tel exemple est représenté sur la figure 2. On voit sur cette figure que les ouvertures 105b formées dans la deuxième couche opaque 104b laissent passer des rayons pouvant provenir de l'une ou l'autre des moitiés 10a, 10b de l'optique 10. La distance entre la première couche opaque 104a et les pixels 102 est inférieure à environ $1,5.p.O.n.$ Comme représenté sur la figure 2, pour chaque paire de pixels, une seule ouverture 105b formée dans la deuxième couche opaque 104b forme un diaphragme supérieur commun à cette paire de pixels. De plus, les tailles des ouvertures 105b formées dans la deuxième couche opaque 104b sont très voisines de la taille d'un des photodétecteurs.

De manière générale, plus la première couche opaque 104a est proche des pixels 102, plus les ouvertures 105a formées dans cette première couche opaque 104a ont des dimensions importantes et proches de la taille des photodétecteurs des pixels 102.

Dans la configuration représentée sur la figure 2, les rayons lumineux provenant de la première moitié droite 10a de l'optique 10 et passant par les ouvertures 105b formées dans la couche opaque supérieure 104b arrivent sur les pixels 102a et ceux de l'autre moitié gauche 10b de l'optique 100 passant par les mêmes ouvertures 105b formées dans la couche opaque supérieure 104b arrivent sur les pixels 102b. Tout autre rayon, c'est-à-dire les rayons provenant de la moitié droite 10a de l'optique 10 et dirigés vers les pixels 102b ainsi que les rayons provenant de la moitié gauche 10b de l'optique 10 et dirigés vers les pixels 102a, est bloqué par l'un et/ou l'autre des diaphragmes formés par les couches opaques 104a, 104b.

Etant donné que les pixels 102 ne reçoivent que les rayons issus de l'une ou l'autre moitié de l'optique 10, les pixels 102a réalisent une intégration de la lumière provenant de la moitié 10a de l'optique 10 et les pixels 102b réalisent une intégration de la lumière provenant de la moitié 10b de l'optique 10.

Ainsi, contrairement à une image capturée par un capteur classique dont le point de vue moyen correspond au centre de l'optique, l'image capturée par les pixels 102a correspond à une image dont le point de vue moyen 12a se situe environ au milieu de la moitié droite 10a de l'optique 10, et l'image capturée par les pixels 102b correspond à une image dont le point de vue moyen 12b se situe environ au milieu de la moitié gauche 10b de l'optique 10.

Compte tenu du masque formé par les couches opaques 104a, 104b au-dessus des pixels 102, environ un quart des rayons issus de l'optique 10 atteignent au moins un des pixels 102, ce qui permet d'avoir deux images bien distinctes obtenues par la capture des rayons provenant de la totalité de la surface de l'optique avec deux points de vues les plus espacés possible (l'espacement est sensiblement égal à la moitié de la largeur de l'optique). La largeur éclairée de chaque pixel 102 est sensiblement égale à la largeur ombragée par le masque dans le plan des pixels 102.

Dans une variante de réalisation avantageuse, et lorsque le circuit intégré imageur 100 est un capteur de type « front-side » (rayons lumineux entrant par la face avant du capteur d'images), les couches opaques 104a, 104b du masque peuvent être formées par les lignes électriques d'interconnexion, généralement à base de métal, formant les liaisons électriques entre les éléments électriques/électroniques du capteur d'images. Le motif de ces lignes électriques respecte donc à la fois celui imposé pour obtenir le câblage électrique souhaité dans le capteur ainsi que celui imposé pour former les diaphragmes.

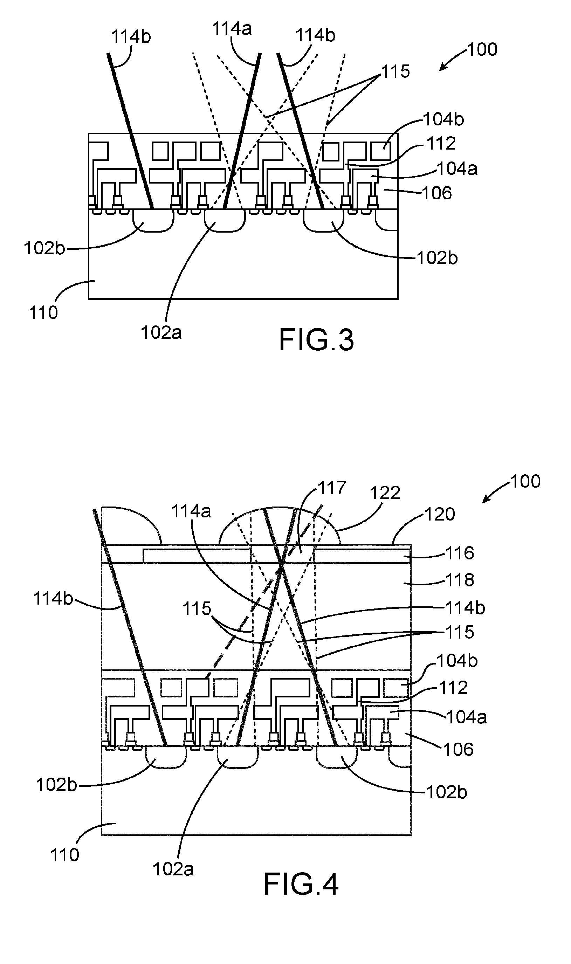

Une partie du circuit intégré imageur 100 réalisé selon cette variante de réalisation est représentée sur la figure 3. Les pixels 102, ici de type CMOS, sont réalisés dans un substrat semiconducteur 110 et sont aptes à réaliser une absorption de rayons lumineux reçus et une séparation des charges électriques générées. Le substrat 110 (et donc les pixels 102) est recouvert d'une couche diélectrique 106 (correspondant aux couches diélectriques 106a, 106b précédemment décrites) dans laquelle sont réalisées les couches d'interconnexions électriques 104a, 104b formant également le masque permettant de sélectionner les rayons lumineux arrivant sur les pixels 102. Les portions électriquement conductrices formant les couches opaques 104a, 104b peuvent être reliées électriquement entre elles et/ou aux photodétecteurs 102 par des vias conducteurs verticaux 112. Des axes de visé 114 des pixels sont également représentés sur cette figure 3.

En effet, pour chaque pixel, le diaphragme supérieur combiné au diaphragme inférieur formés en regard de ce pixel forment ensemble une ouverture orientée selon un certain axe et permettent de sélectionner les rayons lumineux destinés à être reçus par le pixel. Sur l'exemple de la figure 3, les deux pixels 102b comportant des axes de visé 114b orientés vers la gauche sont destinés à recevoir les rayons provenant de la moitié gauche du système optique (non représenté), tandis que le pixel 102a dont l'axe de visé 114a est orienté vers la droite est destiné à recevoir les rayons provenant de la moitié droite du système optique. Outre l'orientation des ouvertures, celles-ci sont également définies par un angle d'acceptance, l'axe de visée formant une bissectrice de cet angle. Cet angle forme un cône dont les limites 115 correspondent à la frontière entre les rayons reçus par le pixel 102 et ceux destinés à être bloqués par les diaphragmes.

Les couches d'interconnexions 104a, 104b permettent également d'empêcher les rayons lumineux d'éclairer les transistors CMOS ainsi que d'autres éléments des pixels ne formant pas les zones photosensibles. Bien que non représentés, le capteur d'images 100 comporte d'autres éléments tels que des microlentilles et des filtres colorés formés au-dessus des couches d'interconnexion électrique 104 et de la couche diélectrique 106, les micro-lentilles permettant de réduire la réfraction et concentrer plus de lumière entre les pistes métalliques. Dans cette variante, par rapport à un capteur d'images standard non stéréoscopique, l'axe optique, ou axe de visée, des diaphragmes formés par les pistes métalliques est basculé et n'est pas perpendiculaire à la face du substrat 110 sur laquelle sont formés les pixels. Les microlentilles peuvent également servir à corriger les aberrations optiques et/ou à minimiser les réflexions optiques dans le capteur.

Si l'épaisseur des couches d'interconnexion (épaisseur des couches elles-mêmes + espace entre ces couches) est insuffisante pour former le masque de sélection des rayons destinés à être reçus par les pixels, il est possible d'ajouter, au-dessus des niveaux d'interconnexions, une couche opaque supplémentaire destinée à former les diaphragmes supérieurs. Une telle configuration est représentée sur la figure 4. Dans cette configuration, les couches d'interconnexions 104a et 104b forment ensemble les diaphragmes inférieurs des pixels, les diaphragmes supérieurs étant réalisés par une couche supplémentaire 116, également à base d'un matériau opaque et dans laquelle des ouvertures 117 sont formées. De plus, comme sur l'exemple de la figure 2, la couche supplémentaire 116 est disposée à une distance particulière des photodétecteurs 102, cette distance étant approximativement égale à $2.p.O.n$. Ainsi, les ouvertures formées dans la couche 116 formant les diaphragmes supérieurs laissent passer des rayons pouvant provenir de l'une ou l'autre des moitiés 10a, 10b de l'optique 10. Les rayons destinés à être reçus par deux pixels voisins passent par une même ouverture formée dans la couche 116.

La couche opaque 116 est disposée sur un support transparent 118 recouvrant le matériau diélectrique 106 dans lequel sont réalisées les couches d'interconnexions 104a, 104b. La couche 116 est recouverte par une couche de passivation 120 sur laquelle sont disposées des lentilles 122.

Dans les exemples précédemment décrits, le capteur d'images 100 peut être un capteur couleur. Dans ce cas, le capteur 100 comporte des filtres colorés disposés en mosaïque, sous les micro-lentilles, formant par exemple un filtre de Bayer. Lorsque deux pixels voisins sont destinés à former deux images, ou vues, distinctes d'une même image stéréoscopique, chaque filtre coloré pourra filtrer les rayons destinés à être capturés par ces deux pixels voisins.

Dans tous les exemples de réalisation décrits, les photodétecteurs peuvent être plus larges que la tache de diffraction, rendant l'effet de la diffraction quasiment négligeable.

La stéréoscopie est obtenue à partir d'une ou plusieurs images prisent selon des points de vues différents le long d'une direction dans l'espace. D'une manière générale, le masque formant les diaphragmes peut donc comporter soit des ouvertures formant de longues lignes couvrant tous les pixels alignés selon une direction perpendiculaire à la direction d'alignement des points de vues des différentes images, soit des ouvertures, par exemple de formes rectangulaires, formant un « damier », pour aligner ou au contraire mettre en quinconce les pixels des différentes images.

Seule l'électronique réalisant le tri de l'information résultante pour reconstituer les images est adaptée selon les dispositions des ouvertures et masquages, afin d'utiliser et traiter les signaux délivrés par les pixels pour reconstituer les différentes vues et construire les images stéréoscopiques.

Lorsque le capteur d'images comporte des filtres colorés, il est possible de réaliser ces filtres tels qu'ils forment également le masque permettant de sélectionner les rayons destinés à être reçus par les pixels. Une telle configuration sera particulièrement intéressante dans le cas d'un capteur « back-side », c'est-à-dire un capteur destinée à recevoir la lumière par sa face arrière, et donc dans lequel le masque ne peut pas être formé par les couches d'interconnexions électriques.

En effet, deux filtres colorés superposés peuvent agir comme deux diaphragmes superposés tels que précédemment décrits car si leurs spectres n'ont pas ou peu de partie commune (filtres de couleurs différentes), alors aucune lumière ne traverse ces deux filtres superposés. Ainsi, selon qu'un rayon lumineux dirigé vers un pixel doit traverser deux filtres colorés de même couleur ou deux filtres colorés de couleurs différentes, la lumière atteindra ou non le pixel.

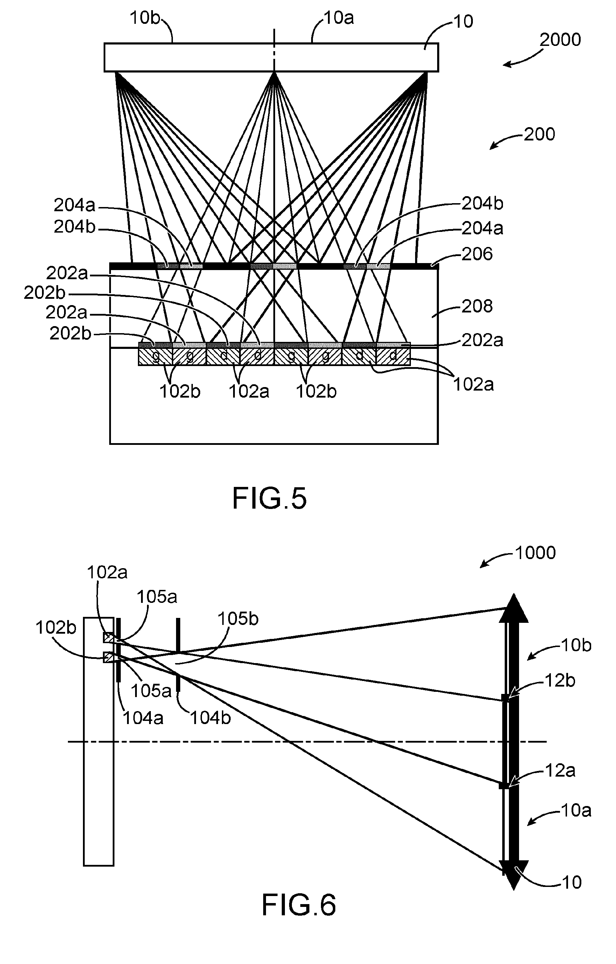

La figure 5 représente un dispositif de capture d'images 2000 comportant un circuit intégré imageur, ou capteur d'images, 200 selon un deuxième mode de réalisation. Dans ce deuxième mode de réalisation, le dispositif 2000 permet de réaliser une capture d'images stéréoscopiques à deux images, ou deux vues, et correspond par exemple à un appareil photo ou une caméra. Le dispositif 2000 comporte également d'autres éléments, et notamment un système optique 10 comprenant au moins une ou plusieurs lentilles et correspondant par exemple à un objectif photographique à focal fixe.

Le circuit intégré imageur 200 stéréoscopique utilise des filtres colorés superposés pour former le masque de sélection des rayons lumineux reçus par les pixels 102 du capteur 200.

Des filtres colorés inférieurs 202 sont disposés juste au-dessus des pixels 102. Pour des raisons de simplification, on considère que les filtres 202 n'ont que deux couleurs, à savoir des filtres rouge 202a et des filtres bleu 202b disposés alternativement les uns à côté des autres. Des filtres colorés supérieurs 204a (rouge) et 204b (bleu) sont disposés au-dessus des filtres colorés inférieurs 202. Les filtres colorés supérieurs 204 sont réalisés dans une couche opaque 206 qui permet de bloquer certains rayons lumineux. Les filtres colorés inférieurs 202 sont séparés des filtres colorés supérieurs 204 par un matériau transparent.

La distance entre les filtres colorés supérieurs 204 et les pixels peut correspondre à la distance séparant les diaphragmes supérieurs et les pixels du dispositif de capture d'images 1000 précédemment décrit. Les filtres colorés inférieurs 202 peuvent être disposés contre les photodétecteurs des pixels 102.

Le double filtrage de couleur réalisé permet qu'alternativement les pixels filtrés en bleu ou en rouge pointent alternativement sur la moitié droite ou la moitié gauche de l'optique. Deux pixels voisins et disposés sous des filtres de couleurs différentes seront ici destinés à former la même image. Sur la figure 5, les pixels 102b sont disposés deux à deux l'un à côté de l'autre et sont destinés à recevoir les rayons lumineux provenant de la moitié gauche 10b du système optique 10. De même, les pixels 102a sont disposés deux à deux l'un à côté de l'autre et sont destinés à recevoir les rayons lumineux provenant de la moitié droite 10a du système optique 10.

Les filtres inférieurs 202 remplissent la même fonction que les diaphragmes inférieurs précédemment décrits. Par contre, les filtres supérieurs 204 sont couplés à des parties opaques de la couche 206 afin de remplir la fonction des diaphragmes supérieurs précédemment décrits.

Dans ce deuxième mode de réalisation, chaque pixel 102 ne reçoit que les rayons lumineux traversant deux filtres superposés de couleurs similaires. Ainsi, les autres rayons dirigés vers ce pixel mais qui trouvent sur leur trajet deux filtres de couleurs différentes ou bien une partie opaque de la couche 206 sont bloqués avant d'atteindre ce pixel.

Les couleurs rouge et bleu des filtres 202 et 204 ne sont là que pour illustration. Afin de former, vis-à-vis d'un pixel, une paire de filtres colorés destinés à bloquer des rayons lumineux indésirables, il est possible d'utiliser n'importe quelle paire de filtres colorés, pourvu que leur spectre ne se recouvre pas ou peu. Il est par exemple possible d'utiliser et combiner les couleurs rouge, vert et bleu de filtres en matrice de Bayer pour former ces filtres colorés superposés.

Le filtrage coloré permettant de déterminer une couleur demande au moins trois couleurs qui sont réparties de façon homogène sur la surface du capteur. Cette disposition des filtres ne concerne que la direction du plan dans laquelle l'effet stéréoscopique est désiré, mais l'ensemble des couleurs doivent être affectées par cette disposition pour que les vues droite et gauche soient reconstruites ensuite par dé-matriçage des couleurs.

En utilisant les filtres colorés pour former les masques de sélection des rayons lumineux, ces filtres remplissent donc deux fonctions, à savoir la restitution des couleurs de l'image et la séparation des points de vue des images stéréoscopiques. Par rapport au premier mode de réalisation dans lequel la sélection des rayons lumineux atteignant les pixels est réalisée par les couches opaques comportant des ouvertures, ce deuxième mode de réalisation permet de capturer une plus grande quantité de lumière car les pixels ainsi que les photodétecteurs peuvent ici être jointifs. On peut donc obtenir ici une meilleure couverture de la surface sensible du capteur d'images.

Sur l'exemple de la figure 5, le nombre de filtres supérieurs 204 est inférieur au nombre de filtres inférieurs 202 (très voisin de moitié moindre), car la configuration est analogue est celle précédemment décrite pour la figure 2 (les diaphragmes supérieurs sont communs aux pixels 102a et 102b).

Toutefois, il est possible que les filtres supérieurs soient plus proches des pixels. Dans ce cas, le nombre des filtres supérieurs 204 est égal au nombre de filtres inférieurs 202.

Dans une autre variante, lorsque le capteur d'images est du type « back-side », il est possible que le masque ne soit pas formé par les filtres colorés, mais par des couches opaques comme précédemment décrit en liaison avec les figures 1 et 2, ces couches étant dans ce cas réalisées du côté de la face arrière du capteur.

Compte tenu du nombre très importants de pixels que peut comporter le capteur d'images (par exemple entre environ 10 et 20 millions de pixels), un seul capteur tel que décrit ci-dessus peut être utilisé pour réaliser une capture d'images stéréoscopiques à N images, ou N vues, avec N par exemple compris entre 2 et 40. Le capteur peut notamment être utilisé pour réaliser une capture d'images stéréoscopiques à 8 images telle que requise par le standard TV en relief appelé « Alioscopy ».

Dans les exemples précédemment décrits, le cône de vision de chaque pixel reporte à l'entrée du système optique un point de vu moyen. Dans le cas d'un circuit intégré imageur non stéréoscopique ne comportant pas de moyens permettant de sélectionner les rayons lumineux reçus par les pixels, le point de vu moyen se trouve sur l'axe optique, au milieu de l'optique, et est le même pour tous les pixels du capteur. Dans le capteur d'images selon l'invention, les points de vue des différentes images capturées se différentient pour chaque sous-ensemble de pixels et se trouvent en général hors de l'axe optique du système optique. La distance entre deux points de vu moyens correspond à la base stéréoscopique. Dans les exemples précédemment décrits, les différents champs optiques captés par les pixels ne se superposent pas (les parties 10a et 10b ne sont pas superposées).

Dans une variante, il est possible que ces champs optiques se superposent, comme représenté sur la figure 6. Les « cônes » de vision des pixels sont plus larges que dans les exemples des figures précédentes.

Ainsi, dans cette configuration représentée sur la figure 6, les points de vue moyens 12a, 12b sont rapprochés l'un de l'autre et une plus grande quantité de rayons lumineux est reçue par les pixels 102 du fait que des rayons lumineux sont communs aux images de points de vue différents capturées par les différents sous-ensembles de pixels. Les parties différentes 10a, 10b à partir desquelles les rayons sont dirigés vers le capteur d'images 100 se superposent également. La base stéréoscopique est donc ici réduite. On peut ainsi choisir à la construction la force des parallaxes stéréoscopiques résultantes en fonction du sujet photographique supposé. La distance entre les pixels 102 et les diaphragmes formés par les couches opaques 104a, 104b peut également être modifiée.

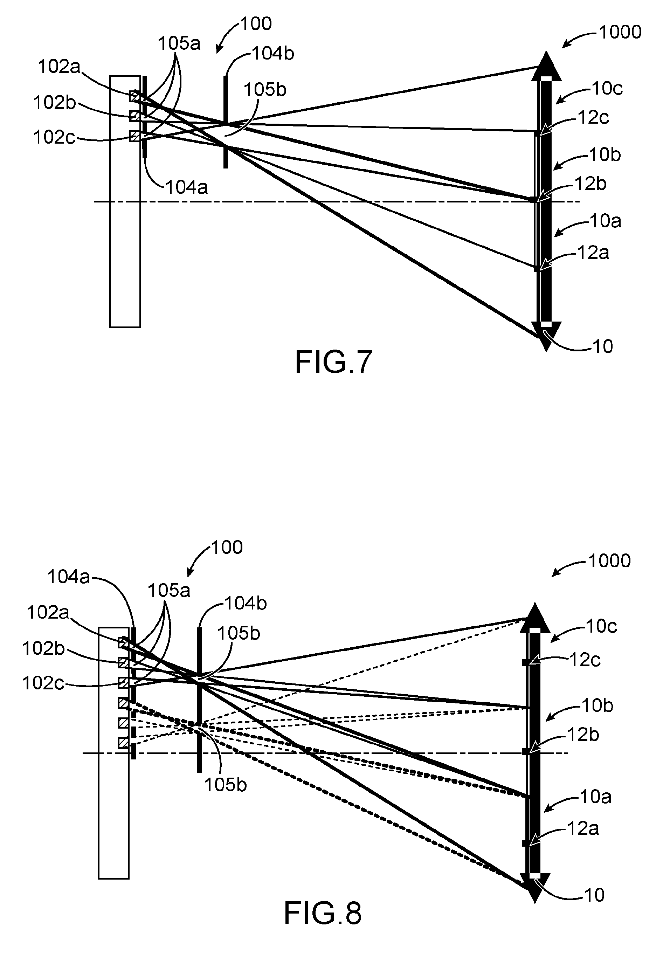

Les figures 7 et 8 représentent schématiquement des variantes du dispositif 1000 de capture d'images stéréoscopiques à trois images. Les rayons issus de trois parties distinctes 10a, 10b, 10c du système optique sont capturés par trois sous-ensembles de pixels 102a, 102b, 102c. Sur l'exemple de la figure 7, les champs optiques capturés se superposent (les parties 10a, 10b et 10c du système optique 10 se superposent), tandis que sur l'exemple de la figure 8, les champs optiques capturés ne se superposent pas.

Plus le nombre d'images capturées simultanément par le dispositif de capture est grand, plus la quantité de rayons lumineux, c'est-à-dire de lumière, reçue par chaque sous-ensemble de pixels pour capturer une des images est réduite. De même, plus le nombre d'images capturées simultanément par le dispositif de capture est grand, plus la base stéréoscopique entre deux points de vue voisins sera petite. Toutefois, la base stéréoscopique peut également être adaptée en fonction du système optique utilisé.

La position de mise au point du dispositif de capture d'images selon l'invention n'a pas exactement le même effet que pour une capture d'images non stéréoscopiques. Le système est en général calculé pour une image nette entre l'infini et des plans moyennement proches, et cela avec une ouverture optique fixe. Il est par exemple possible de choisir une mise au point fixe en position hyperfocale.

Lorsque la mise au point est réalisée sur des plans proches, le circuit intégré imageur reculant par rapport au système optique, les cônes définissant les points de vue se superposent. Du fait que le diamètre de l'optique ne change pas, les points de vue se rapprochent et la base stéréoscopique se réduit.

Pour un recul égal à deux fois la focale (c'est-à-dire pour une image de taille égale à l'objet), il n'y a plus d'effet stéréoscopique avec un capteur prévu pour fonctionner à l'infini.

En conséquence, pour la macrophotographie, le circuit intégré stéréoscopique est défini spécialement pour cette application et est par conséquent limité en profondeur de relief, notamment pour les applications endoscopiques.

Le système optique du dispositif de capture d'images selon l'invention peut comporter des objectifs à miroirs dit catadioptriques pouvant atteindre des diamètres importants. Du fait que la base stéréoscopique ne s'étend que dans une seule direction, le système optique peut être construit avec une grande dimension dans la direction de la base stéréoscopique et une dimension plus petite dans la direction perpendiculaire à la base stéréoscopique. Le système optique pourra comporter deux (ou plus) périscopes disposés têtes-bêches, transportant les images périphériques devant les différents cônes de vison du capteur d'images.

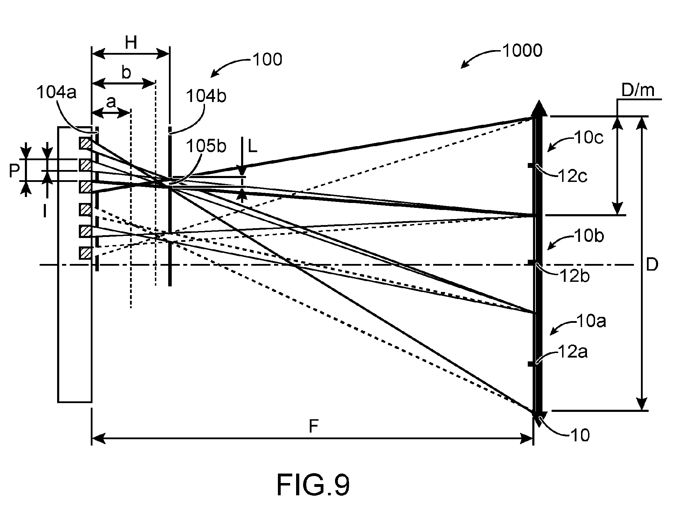

On décrit maintenant, en liaison avec la figure 9, les calculs permettant de dimensionner et positionner les différents éléments du dispositif de capture d'images 1000 précédemment décrit en liaison avec les figures 2, 6, 7 et 8.

On considère que l'objet est à l'infini et que l'image est nette, et donc que le plan des pixels 102 est à la focale $F$.

On a également :

$D$ : diamètre (arrière) du système optique 10,

$D/m$ : largeur vue par chaque pixel, correspondant au champ optique ou encore à la dimension d'une des parties (référencées 10a, 10b ou 10c sur la figure 9) du système optique 10 dans la direction stéréoscopique,

$N$ : nombre d'images, ou vues, formant une image stéréoscopique (trois sur l'exemple de la figure 9 ; $m$ et $N$ pouvant être différents),

$H$ : position du plan des diaphragmes supérieurs, c'est-à-dire la distance entre les diaphragmes supérieurs (ou filtre colorés supérieurs) et les pixels,

$L$ : largeur d'une ouverture de diaphragme supérieur (correspondant à la dimension d'un côté ou du diamètre d'un des trous 105b),

$p$ : pas des pixels, c'est-à-dire la distance entre deux pixels 102 (par exemple égale à 5 $\mu$m, mais pouvant par exemple varier de 1 $\mu$m à 50 $\mu$m suivant l'application),

$l$ : largeur d'un photodétecteur dans un pixel 102,

$a$ : hauteur de croisement des rayons extrêmes (rayons délimitant le cône de vision des pixels) pour chaque pixel,

$b$ : la hauteur de croisement des rayons extrêmes pour le nombre de vues choisi (rayons délimitant le cône de vision de $N$ pixels voisins),

$n$ : indice du matériau diélectrique séparant les couches opaques 104 (ou les filtres colorés).

On voit sur la figure 9 que les valeurs de $a$ et $b$ sont les mêmes pour tous les pixels 102. Les valeurs des angles des rayons se croisant aux points $a$ et $b$ étant faibles (inférieurs à environ 25°), la loi de Descartes pour la réfraction peut s'approximer par la relation :

$$angle\ d'incidence = n\ *\ angle\ de\ réfraction$$

De plus, du fait que chaque largeur $L$ et le groupe de $N$ pixels associés ont des dimensions très petites devant la dimension de l'ensemble du dispositif 1000, il est possible de considérer que tous les rayons passant par une ouverture n'ont que très peu d'écart angulaire entre eux, et qu'ils sont donc, en première approximation, réfractés de la même valeur. On a donc, pour simplifier : $O = F/D$ (appelé « ouverture de l'optique ») et $Px = ((N-1)p+1)$.

$O$ est généralement compris entre 2 et 3 et a une valeur fixe.

On cherche les valeurs de $H$ et $L$ avec $a$ et $b$ inconnus. Les autres variables sont des paramètres de la structure optique.

Les relations des triangles formés par les rayons lumineux donnent :

$$(F-b)/D = b/((N-1).p+l) = b/px$$

$$(H-b)/L = b/px$$

$$(F-a)/(D/m) = a/l$$

$$(H-a)/L = a/l$$

On détermine d'abord $a$ et $b$ :

$$b = O.D.px/(D+px)$$

$$b = H.px/(px+L)$$

$$a = m.D.O.l/(m.l+D)$$

$$a = l.H/(L+l)$$

On obtient donc:

$$O.D/(D+px) = H/(px+L)$$

$$m.D.O/(D+m.l) = H/(L+l)$$

Calcul de L :

$$(L+px)/(D+px) = m.(L+l)/(D+m.l)$$

$$(L+px).(D+m.l) = m.(L+l).(D+px)$$

$$L.(D+m.l-m.D-m.px) = (m.l.D+m.l.px-D.px-m.l.px)$$

$$L = (m.l-px)/((1-m)-m/D.(l-px))$$

En ré-exprimant px, on obtient :

$$L = (l.(m-1)-(N-1).p) / ((1-m)-(m/D).(N-1).p)$$

Dans le cas particulier où $p = 2.1$ et $m = N$, on a :

$$L = (N-1).p/(-(N-1)(N.p+D)/D)$$

si $D >> p$, alors $L = p$

Ainsi, on voit que la largeur $L$ des ouvertures 105b est peu influencée par le système optique.

Calcul de $H$ :

$$H = m.D.O.(L+l)/(m.l+D)$$

$$H = m.D.O/(m.l+D).((l.(m-1)-(N-1).p)+l.((1-m)-(m/D).(N-1).p))/((1-m)-(m/D).(N-1).p)$$

$$H = m.D.O/(m.l+D).(-(N-1).p-l.(m/D).(N-1).p)/((1-m)-(m/D).(N-1).p)$$

$$H = m.D.O/(m.l+D).(-(N-1).p.(1-l.m/D))/((1-m)-(m/D).(N-1).p)$$

$$H = m.O.(N-1).p/((m-1) + (m/D).(N-1).p)$$

(Dans le cas d'un matériau d'indice $n \neq 1$ entre les couches 104a, 104b, la valeur de H est multipliée par $n$)

Ainsi, dans le cas de la figure 9 : $m = N = 3$, on a donc $H = 6.O.p/(2+6.p/D)$

Si $D \gg p$ alors $H = 3.O.p$.

Dans le cas particulier où $m=N$, on a :

$$H = N.O.p/(1+m.p/D)$$

Si $D \gg p$, alors $H = N.O.p$

Ainsi, on voit que la hauteur $H$ est dépendante de l'ouverture $F/D$ du système optique.

La hauteur $H$ peut avoir une valeur comprise entre environ 10 $\mu$m et 100 $\mu$m, et par exemple égale à environ 20 $\mu$m.

On donne ci-dessous deux exemples numériques :

Si $O$ = 2 ; $p$ = 3 $\mu$m ; $n$ = 1,48 ; $N$ = 2
On a alors $H$ = 17,76 $\mu$m.
Si $O$ = 3 ; $p$ = 5 $\mu$m ; $n$ = 1,66 ; $N$ = 3
On a alors $H$ = 74,7 $\mu$m.

Dans ces conditions, la largeur de chaque fente (ou carré) diaphragme 150b dans le masque supérieur 104b est très voisine du pas des pixels p. Sa disposition (courbure des fentes par exemple) dépend aussi de l'indice $n$ du matériau remplissant l'espace.

Ces équations sont issues de règles de construction du circuit intégré imageur respectées lors de la conception de celui-ci :

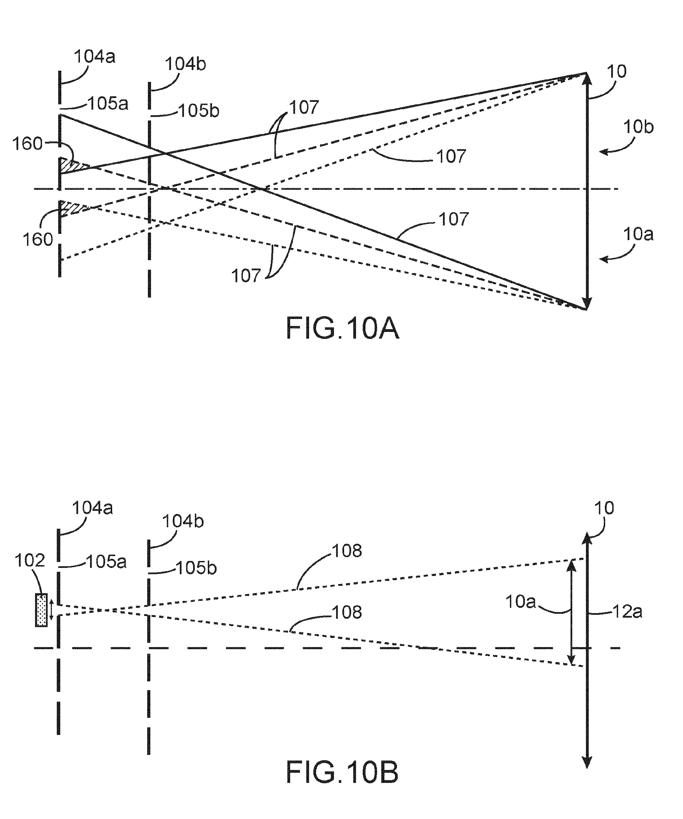

- Comme représenté sur la figure 10A, les lignes 107 représentant les limites des rayons pouvant passer par les ouvertures 105b du masque supérieur 104b, provenant du système optique 10 et se croisant entre les couches 104a et 104b formant les diaphragmes, forment des cônes. Les intersections de ces cônes forment des zones 160. Les couches 104a, 104b et les ouvertures 105a, 105b sont donc réalisées telles que les intersections de ces zones 160 avec la couche 104a se produisent au niveau de parties opaques de la couche 104a et non au niveau des ouvertures 105a.

- La figure 10B illustre le fait que les ensembles de rayons lumineux, délimités sur la figure 10B par des lignes 108, issus d'une portion 10a du système optique 10 vue par un pixel 102 forment des cônes. L'alignement d'une ouverture 105a et d'une ouverture 105b formant respectivement un diaphragme inférieur et un diaphragme supérieur vis-à-vis d'un pixel 102 définit un point de vue moyen 12a du pixel 102. De plus, les largeurs des ouvertures 105a, 105b définissent la portion 10a du système optique 10 vue par le pixel 102.

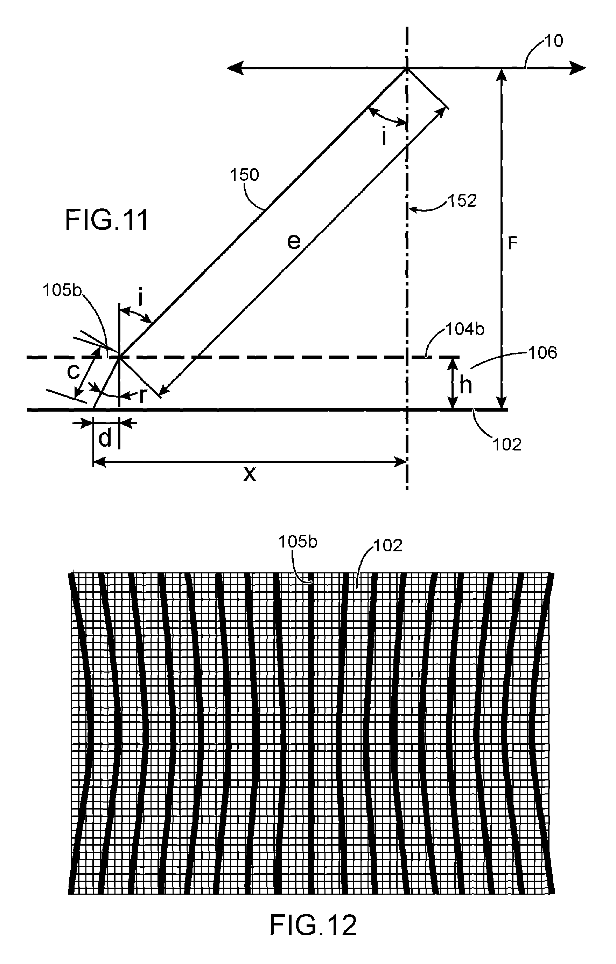

On se réfère à la figure 11 pour décrire la réfraction subie par un rayon lumineux 150 depuis le système optique 10 jusqu'aux pixels 102. On cherche à déterminer le décalage d entre une ouverture 105b vis-à-vis d'un pixel 102 induit par la réfraction due à l'indice *n* du matériau transparent 106. Le matériau 106 peut être choisi de préférence tel que son indice de réfraction *n* soit le plus proche possible de 1, et est par exemple de la silice, de la silice poreuse, un polymère, etc. *n* est généralement compris entre environ 1 et 1,7.

Soit *i* l'angle formé entre le rayon lumineux 150 et l'axe optique 152 du système optique 10 entre le système optique 10 et le plan des diaphragmes supérieurs 104b, et *r* l'angle formé entre le rayon lumineux 150 et l'axe optique 152 du système optique 10 dans le matériau 106.

Selon la loi de Descartes, on a :

$$sin(i) = n.sin(r)$$

$$Or, \; sin(i) = (x-d)/e \; \text{et} \; sin(r) = d/c$$

avec e correspondant à la longueur du rayon lumineux 150 entre le système optique 10 et le plan des diaphragmes supérieurs 104b, et *c* correspondant à la longueur du rayon lumineux 150 dans le matériau diélectrique 106.

Or, $c^2 = d^2 + h^2$ et $b^2 = (x-d)^2 + (F-h)^2$

On peut donc calculer $(x-d).c = n.d.b$

Soit $(x-d)^2.(d^2+h^2) = n^2.d^2.((x-d)^2+(F-h)^2)$

Dans cette équation, la variable d est la seule inconnue. On va donc développer une équation polynomiale en *d* qui donnera les solutions :

$$d^4.(1-n^2)-2d^3.x.(1-n^2)+d^2.(x^2.(1-n^2)+h^2-n^2.(F-h)^2)-2d.x.h^2+h^2.x^2 = 0$$

Ou encore :

$$d^4-2d^3.x+d^2.(x^2+h^2-n^2.F.(F-2h)/(1-n^2))-2d.x.h^2/(1-n^2)+h^2.x^2/(1-n^2) = 0$$

Les valeurs de *d*, solutions de ce polynôme, se retrouvent alors par des méthodes numériques connues.

Dans le cas où *n* est sensiblement égal à 1, cette équation se simplifie et donne bien le déplacement $d = h.x/F$

Pour un indice *n* donné, la position des ouvertures est donc dépendante de la focal *F* du système optique.

Dans les exemples de réalisation précédemment décrits, les dimensions des ouvertures réalisées dans une même couche opaque (et notamment les ouvertures 105a formant les diaphragmes inférieurs) ont des dimensions sensiblement similaires. Toutefois, de manière générale, les dimensions des ouvertures réalisées dans une même couche opaque peuvent être différentes les unes des autres. Dans ce cas, les différents photodétecteurs ne fourniront pas des signaux électriques identiques pour une même excitation lumineuse incidente.

La figure 12 représente schématiquement et vue de dessus un exemple de réalisation d'ouvertures 105 destinées à former les diaphragmes supérieurs d'un circuit intégré imageur selon l'invention dans le cas où l'indice n est supérieur à 1.

Les ouvertures 105b formées dans le masque sont représentées par des lignes disposées au-dessus d'un quadrillage représentant les pixels 102. La courbure des ouvertures 105b est le résultat du décalage d vis-à-vis de l'alignement des pixels. Dans l'exemple représenté sur la figure 11, les ouvertures 105b forment des tranchées alignées les unes à côté des autres. Dans une variante, les ouvertures 105 peuvent être non pas alignées mais réparties en quinconce à chaque ligne de pixels, mais toujours en présentant la courbure de la figure 11, dans les deux directions du plan.

Lorsque les moyens permettant de sélectionner les rayons lumineux ne sont pas réalisés par des filtres colorés ou des couches d'interconnexions électriques existantes, et comportent des couches opaques dédiées, ces couches sont réalisées dans ou à la suite de la construction des éléments du circuit intégré imageur. Leur réalisation ne présente pas de particularité par rapport aux étapes mises en oeuvre pour la réalisation d'un circuit intégré imageur classique : dépôts de couches uniformes, gravure de ces couches par photolithographie, etc.

Les couches opaques peuvent être réalisées à base de métal. Dans un mode de réalisation avantageux, chaque couche opaque peut être formée d'une couche de matériau opaque disposée entre une ou plusieurs couches de matériau antireflet, par exemple à base de métal ou d'un oxyde métallique. Par exemple, lorsque les couches opaques sont composées d'aluminium, ces couches anti-reflet peuvent être composées de titane ou de $TiO_2$ ou tout autre matériau tel que son indice de réfraction $n$ correspond à la racine carrée de ($n$ du métal * $n$ du milieu autour du métal).

L'épaisseur de chaque couche opaque peut être sensiblement égale au quart de la longueur d'onde moyenne de travail du dispositif de capture d'images.

## Revendications

1. Circuit intégré imageur (100, 200) destiné à coopérer avec un système optique (10) configuré pour diriger des rayons lumineux issus d'une scène vers une face d'entrée (101) du circuit intégré imageur (100, 200), le circuit intégré imageur (100, 200) étant configuré pour réaliser une capture stéréoscopique simultanée de $N$ images correspondant à $N$ vues distinctes de la scène, $N$ étant un entier supérieur à 1, chacune des $N$ images correspondant à des rayons lumineux dirigés par une portion (10a, 10b, 10c) du système optique (10) différente de celles dirigeant les rayons lumineux correspondant aux $N-1$ autres images, le circuit intégré imageur (100, 200) comportant :

   - $N$ sous-ensembles de pixels (102) réalisés sur un même substrat (110), chacun des $N$ sous-ensembles de pixels étant destiné à réaliser la capture d'une des $N$ images qui lui est associée,
   - des moyens (104a, 104b, 202, 204, 206) interposés entre chacun des $N$ sous-ensembles de pixels (102) et la face d'entrée (101) du circuit intégré imageur (100, 200), et configurés pour laisser passer les rayons lumineux correspondant à l'image associée audit sous-ensemble de pixels et bloquer les autres rayons lumineux dirigés depuis le système optique (10) vers ledit sous-ensemble de pixels,

   et dans lequel lesdits moyens comportent :

   - au moins deux couches opaques (104a, 104b) superposées l'une au-dessus de l'autre, disposées entre les pixels (102) et la face d'entrée (101) du circuit intégré imageur (100), les deux couches opaques (104a, 104b) étant traversées par une pluralité de trous (105a, 105b) formant, vis-à-vis de chaque pixel (102), au moins une paire de diaphragmes superposés aptes à laisser passer une partie des rayons lumineux correspondant à l'image associée au sous-ensemble de pixels dont fait partie ledit pixel et aptes à bloquer les autres rayons lumineux dirigés depuis le système optique (10) vers ledit pixel et correspondant aux autres images, ou
   - au moins deux niveaux de filtres colorés (202, 204) superposés l'un au-dessus de l'autre, disposés entre les pixels (102) et la face d'entrée (101) du circuit intégré imageur (200), et formant, vis-à-vis de chaque pixel (102), au moins une première paire de filtres colorés superposés configurés pour laisser passer une partie des rayons lumineux correspondant à l'image associée au sous-ensemble de pixels dont fait partie ledit pixel et au moins une deuxième paire de filtres colorés superposés configurés pour bloquer les autres rayons lumineux dirigés depuis le système optique (10) vers ledit pixel et correspondant aux autres images.

2. Circuit intégré imageur (100) selon la revendication 1, dans lequel le nombre de trous (105a, 105b) traversant chacune des deux couches opaques (104a, 104b) est égal au nombre total de pixels des $N$ sous-ensembles de pixels (102).

3. Circuit intégré imageur (100) selon l'une des revendications précédentes, dans lequel, lorsque N = 2 et que ladite portion (10a, 10b) du système optique (10) correspond à une moitié du système optique (10), une distance $H$ entre les pixels (102) et une seconde des deux couches opaques (104b), une première des deux couches opaques (104a) étant disposée entre les pixels (102) et la seconde des deux couches opaques (104b), est telle que $H \leq 1,5.p.O.n,$ avec :

   $p$ : pas des pixels (102),
   $O$ : ouverture numérique du système optique (10),

$n$ : indice optique d'un matériau transparent (106) disposé entre les deux couches opaques (104a, 104b).

**4.** Circuit intégré imageur (100) selon la revendication 1, dans lequel le nombre de trous (105a) traversant une première (104a) des deux couches opaques est égal au nombre total de pixels des $N$ sous-ensembles de pixels (102), et le nombre de trous (105b) traversant une seconde (104b) des deux couches opaques est égal à $(M_{pix}/N) \pm 1$, avec $M_{pix}$ correspondant au dit nombre total de pixels, ladite première des deux couches opaques (104a) étant disposée entre les pixels (102) et la seconde (104b) des deux couches opaques.

**5.** Circuit intégré imageur (100) selon la revendication 4, dans lequel une distance $H$ entre les pixels (102) et la seconde (104b) des deux couches opaques est telle que $H = \dfrac{n.m.O.(N-1).p}{(m-1)+(m/D).(N-1).p}$ , avec :

$D$ : diamètre du système optique (10),
D/m : diamètre d'une desdites portions (10a, 10b, 10c) du système optique (10),
$p$ : pas des pixels (102),
$O$ : ouverture numérique du système optique (10),
$n$ : indice optique d'un matériau transparent (106) disposé entre les deux couches opaques (104a, 104b),

**6.** Circuit intégré imageur (100) selon l'une des revendications précédentes, dans lequel au moins l'une des couches opaques (104a, 104b) est formée par des lignes d'interconnexions électriques reliées électriquement aux pixels (102).

**7.** Circuit intégré imageur (100) selon l'une des revendications 1 à 5, dans lequel les pixels (102) sont disposés entre la face d'entrée (101) du circuit intégré imageur (100) et des lignes d'interconnexions électriques reliées électriquement aux pixels (102).

**8.** Circuit intégré imageur (100) selon l'une des revendications précédentes, dans lequel les trous (105a, 105b) formés dans les couches opaques (104a, 104b) forment des tranchées alignées les unes à côté des autres ou dans lequel les trous sont disposés en quinconce.

**9.** Circuit intégré imageur (100) selon l'une des revendications précédentes, dans lequel chaque pixel (102) comporte des éléments électriques et/ou électroniques non photosensibles masqués par les couches opaques (104a, 104b).

**10.** Circuit intégré imageur (100) selon l'une des revendications précédentes, dans lequel les deux couches opaques (104a, 104b) sont espacées l'une de l'autre par de l'air et/ou du $SiO_2$ et/ou du $SiO_2$ poreux et/ou une résine optiquement transparente aux rayons lumineux destinés à être capturés par les pixels (102).

**11.** Circuit intégré imageur (100) selon l'une des revendications précédentes, dans lequel les deux couches opaques (104a, 104b) sont composées de métal et/ou de résine et/ou recouvertes d'au moins une couche antireflet.

**12.** Circuit intégré imageur (200) selon la revendication 1, dans lequel au moins un des deux niveaux de filtres colorés (204) comporte également des portions de matériau opaque (206) configurés pour bloquer, vis-à-vis de chaque pixel (102), une partie desdits autres rayons lumineux dirigés depuis le système optique (10) vers ledit pixel (102) et correspondant aux autres images.

**13.** Circuit intégré imageur (200) selon l'une des revendications 1 ou 12, dans lequel les pixels (102) sont disposés entre la face d'entrée (101) du circuit intégré imageur (200) et des lignes d'interconnexions électriques reliées électriquement aux pixels (102).

**14.** Circuit intégré imageur (200) selon l'une des revendications 1, 12 ou 13, dans lequel les deux niveaux de filtres colorés (202, 204) sont espacées l'un de l'autre par de l'air et/ou du $SiO_2$ et/ou une résine optiquement transparente aux rayons lumineux destinés à être capturés par les pixels (102).

**15.** Circuit intégré imageur (100, 200) selon l'une des revendications précédentes, dans lequel les pixels (102) sont configurés pour capturer des images dans le domaine visible et/ou infrarouge.

**16.** Dispositif de capture d'images stéréoscopiques (1000, 2000) comportant au moins un circuit intégré imageur (100, 200) selon l'une des revendications précédentes et au moins un système optique (10) configuré pour diriger des rayons lumineux issus d'une scène vers le circuit intégré imageur (100, 200).

**17.** Dispositif de capture d'images (1000, 2000) selon la revendication 16, dans lequel les pixels (102) du circuit intégré imageur (100, 200) sont configurés pour capturer des images dans le domaine infrarouge, ledit dispositif (1000, 2000) étant un bolomètre.

**Patentansprüche**

**1.** Bildgebender integrierter Schaltkreis (100, 200), der dazu bestimmt ist, mit einem optischen System (10) zusammenzuwirken, das dazu konfiguriert ist, aus einer Szene stammende Lichtstrahlen zu einer Eingangsseite (101) des bildgebenden integrierten Schaltkreises (100, 200) zu richten, wobei der bildgebende integrierte Schaltkreis (100, 200) dazu konfiguriert ist, eine simultane stereoskopische Erfassung von N Bildern durchzuführen, die N verschiedenen Ansichten der Szene entsprechen, wobei N eine ganze Zahl über 1 ist, wobei jedes der N Bilder Lichtstrahlen entspricht, die von einem Abschnitt (10a, 10b, 10c) des optischen Systems (10) gerichtet werden, der sich von denjenigen unterscheidet, welche die Lichtstrahlen richten, die den N-1 weiteren Bildern entsprechen, wobei der bildgebende integrierte Schaltkreis (100, 200) aufweist:

- N Untereinheiten von Pixeln (102), die an einem gleichen Substrat (110) ausgebildet sind, wobei jede der N Untereinheiten von Pixeln dazu bestimmt ist, das Erfassen eines der N Bilder durchzuführen, das ihr zugeordnet ist,
- Mittel (104a, 104b, 202, 204, 206), die zwischen jeder der N Untereinheiten von Pixeln (102) und der Eingangsseite (101) des bildgebenden integrierten Schaltkreises (100, 200) eingefügt sind und dazu konfiguriert sind, die Lichtstrahlen passieren zu lassen, die dem Bild entsprechen, das der genannten Untereinheit von Pixeln zugeordnet ist, und die weiteren Lichtstrahlen abzuhalten, die vom optischen System (10) zu der Untereinheit von Pixeln gerichtet werden,

und wobei die Mittel enthalten:

- zumindest zwei lichtundurchlässige Schichten (104a, 104b), die übereinanderliegend zwischen den Pixeln (102) und der Eingangsseite (101) des bildgebenden integrierten Schaltkreises (100) angeordnet sind, wobei die beiden lichtundurchlässigen Schichten (104a, 104b) von einer Mehrzahl von Löchern (105a, 105b) durchsetzt sind, welche gegenüber jedem Pixel (102) zumindest ein Paar von übereinanderliegenden Blenden bilden, die dazu geeignet sind, einen Teil der Lichtstrahlen passieren zu lassen, der dem Bild entspricht, das der Untereinheit von Pixeln zugeordnet ist, zu denen das genannte Pixel gehört, und die dazu geeignet sind, die weiteren Lichtstrahlen abzuhalten, die von dem optischen System (10) zu dem genannten Pixel gerichtet sind und den weiteren Bildern entsprechen, oder
- zumindest zwei Farbfilterstufen (202, 204), die übereinanderliegend zwischen den Pixeln (102) und der Eingangsseite (101) des bildgebenden integrierten Schaltkreises (100) angeordnet sind und gegenüber jedem Pixel (102) zumindest ein erstes Paar von übereinanderliegenden Farbfiltern bilden, die dazu konfiguriert sind, einen Teil der Lichtstrahlen passieren zu lassen, der dem Bild entspricht, das der Untereinheit von Pixeln zugeordnet ist, zu denen das genannte Pixel gehört, sowie zumindest ein zweites Paar von Farbfiltern, die übereinanderliegen und dazu konfiguriert sind, die weiteren Lichtstrahlen abzuhalten, die von dem optischen System (10) zu dem Pixel gerichtet sind und den weiteren Bildern entsprechen.

**2.** Bildgebender integrierter Schaltkreis (100) nach Anspruch 1, wobei die Anzahl an Löchern (105a, 105b), die jede der beiden lichtundurchlässigen Schichten (104a, 104b) durchsetzen, gleich der Gesamtzahl an Pixeln der N Untereinheiten von Pixeln (102) ist.

**3.** Bildgebender integrierter Schaltkreis (100) nach einem der vorangehenden Ansprüche, wobei dann, wenn N = 2 und der genannte Abschnitt (10a, 10b) des optischen Systems (10) einer Hälfte des optischen Systems (10) entspricht, und bei einem Abstand $H$ zwischen den Pixeln (102) und einer zweiten der beiden lichtundurchlässigen Schichten (104b), wobei eine erste der beiden lichtundurchlässigen Schichten (104a) zwischen den Pixeln (102) und der zweiten der beiden lichtundurchlässigen Schichten (104b) angeordnet ist, der genannte Abstand derart ist, dass $H \leq 1{,}5 \cdot p.O.n$, mit:

*p*: Schritt der Pixel (102),

*O*: numerische Apertur des optischen Systems (10),

*n*: optischer Index eines transparenten Materials (106), das zwischen den beiden lichtundurchlässigen Schichten (104a, 104b) angeordnet ist.

4. Bildgebender integrierter Schaltkreis (100) nach Anspruch 1, wobei die Anzahl an Löchern (105a), die eine erste (104a) der beiden lichtundurchlässigen Schichten durchsetzen, gleich der Gesamtzahl an Pixeln der N Untereinheiten von Pixeln (102) ist, und die Anzahl an Löchern (105b), die eine zweite (104b) der beiden lichtundurchlässigen Schichten durchsetzen, gleich $(M_{pix}/N) \pm 1$ ist, wobei $M_{pix}$ der genannten Gesamtzahl an Pixeln entspricht, wobei die erste der beiden lichtundurchlässigen Schichten (104a) zwischen den Pixeln (102) und der zweiten (104b) der beiden lichtundurchlässigen Schichten angeordnet ist.

5. Bildgebender integrierter Schaltkreis (100) nach Anspruch 4, wobei ein Abstand H zwischen den Pixeln (102) und der zweiten (104b) der beiden lichtundurchlässigen Schichten derart ist, dass $H = \dfrac{n.m.O.(N-1).p}{(m-1)+(m/D).(N-1).p}$

mit:

D: Durchmesser des optischen Systems (10),

*D/m*: Durchmesser eines der Abschnitte (10a, 10b, 10c) des optischen Systems (10),

*p*: Schritt der Pixel (102),

*O*: numerische Apertur des optischen Systems (10),

*n*: optischer Index eines transparenten Materials (106), das zwischen den beiden lichtundurchlässigen Schichten (104a, 104b) angeordnet ist.

6. Bildgebender integrierter Schaltkreis (100) nach einem der vorangehenden Ansprüche, wobei zumindest eine der lichtundurchlässigen Schichten (104a, 104b) aus Leitungen von elektrischen Verschaltungen gebildet ist, die elektrisch mit den Pixeln (102) verbunden sind.

7. Bildgebender integrierter Schaltkreis (100) nach einem der Ansprüche 1 bis 5, wobei die Pixel (102) zwischen der Eingangsseite (101) des bildgebenden integrierten Schaltkreises (100) und den Leitungen von elektrischen Verschaltungen gebildet ist, die elektrisch mit den Pixeln (102) verbunden sind.

8. Bildgebender integrierter Schaltkreis (100) nach einem der vorangehenden Ansprüche, wobei die in den lichtundurchlässigen Schichten (104a, 104b) ausgebildeten Löcher (105a, 105b) nebeneinandergereihte Gräben bilden oder wobei die Löcher auf Lücke angeordnet sind.

9. Bildgebender integrierter Schaltkreis (100) nach einem der vorangehenden Ansprüche, wobei jedes Pixel (102) nicht lichtempfindliche, elektrische und/oder elektronische Elemente aufweist, die von den lichtundurchlässigen Schichten (104a, 104b) verdeckt werden.

10. Bildgebender integrierter Schaltkreis (100) nach einem der vorangehenden Ansprüche, wobei die beiden lichtundurchlässigen Schichten (104a, 104b) durch Luft und/oder $SiO_2$ und/oder poröses $SiO_2$ und/oder gegenüber Lichtstrahlen optisch transparentes Harz voneinander beabstandet sind, welche Lichtstrahlen von den Pixeln (102) erfasst werden sollen.

11. Bildgebender integrierter Schaltkreis (100) nach einem der vorangehenden Ansprüche, wobei die beiden lichtundurchlässigen Schichten (104a, 104b) aus Metall und/oder Harz zusammengesetzt sind und/oder mit zumindest einer Antireflexschicht überdeckt sind.

12. Bildgebender integrierter Schaltkreis (200) nach Anspruch 1, wobei zumindest eine der beiden Farbfilterstufen (204) auch Abschnitte aus lichtundurchlässigem Material (206) aufweist, die dazu konfiguriert sind, um gegenüber jedem Pixel (102) einen Teil der weiteren Lichtstrahlen abzuhalten, die von dem optischen System (10) zu dem Pixel (102) gerichtet werden und den weiteren Bildern entsprechen.

13. Bildgebender integrierter Schaltkreis (200) nach einem der Ansprüche 1 oder 12, wobei die Pixel (102) zwischen der Eingangsseite (101) des bildgebenden integrierten Schaltkreises (200) und den Leitungen der elektrischen Verschaltungen, die elektrisch mit den Pixeln (102) verbunden sind, angeordnet sind.

14. Bildgebender integrierter Schaltkreis (200) nach einem der Ansprüche 1, 12 oder 13, wobei die beiden Farbfilterstufen (202, 204) durch Luft und/oder SiO$_2$ und/oder ein gegenüber Lichtstrahlen optisch transparentes Harz voneinander beabstandet sind, welche Lichtstrahlen von den Pixeln (102) erfasst werden sollen.

15. Bildgebender integrierter Schaltkreis (100, 200) nach einem der vorangehenden Ansprüche, wobei die Pixel (102) dazu konfiguriert sind, Bilder im sichtbaren und/oder im Infrarot-Bereich zu erfassen.

16. Vorrichtung zum Erfassen von stereoskopischen Bildern (1000, 2000), enthaltend zumindest einen bildgebenden integrierten Schaltkreis (100, 200) nach einem der vorangehenden Ansprüche und zumindest ein optisches System (10), das dazu konfiguriert ist, von einer Szene stammende Lichtstrahlen zum bildgebenden integrierten Schaltkreis (100, 200) zu richten.

17. Vorrichtung zum Erfassen von stereoskopischen Bildern (1000, 2000) nach Anspruch 16, wobei die Pixel (102) des bildgebenden integrierten Schaltkreises (100, 200) dazu konfiguriert sind, Bilder im Infrarot-Bereich zu erfassen, wobei die Vorrichtung (1000, 2000) ein Bolometer ist.

**Claims**

1. An imager integrated circuit (100, 200) intended to cooperate with an optical system (10) configured to direct light rays from a scene to an inlet face (101) of the imager integrated circuit (100, 200), said imager integrated circuit being configured to perform a simultaneous stereoscopic capture of N images corresponding to N distinct views of the scene, N being an integer higher than 1, each of the N images corresponding to light rays directed by a portion (10a, 10b, 10c) of the optical system (10) which is different from those directing the light rays corresponding to the N-1 other images, the imager integrated circuit (100, 200) including:

   - N subsets of pixels (102) made on a same substrate (110), each of the N subsets of pixels being intended to perform the capture of one of the N images associated therewith,
   - means (104a, 104b, 202, 204, 206) interposed between each of the N subsets of pixels (102) and the inlet face (101) of the imager integrated circuit (100, 200), and configured to pass the light rays corresponding to the image associated with said subset of pixels and block the other light rays directed from the optical system (10) to said subset of pixels,

   and wherein said means include:

   - at least two opaque layers (104a, 104b) superimposed one above the other, provided between the pixels (102) and the inlet face (101) of the imager integrated circuit (100), both opaque layers (104a, 104b) having, passing therethrough, a plurality of holes (105a, 105b) forming, towards each pixel (102), at least one pair of superimposed diaphragms capable of passing a part of the light rays corresponding to the image associated with the subset of pixels of which said pixel is part and which are capable of blocking other light rays directed from the optical system (10) to said pixel and corresponding to the other images, or
   - at least two levels of colour filters (202, 204) superimposed one above each other, arranged between the pixels (102) and the inlet face (101) of the imager integrated circuit (200) and forming, towards each pixel (102), at least one first pair of superimposed colour filters configured to pass a part of the light rays corresponding to the image associated with the subset of pixels of which said pixel is part and at least one second pair of superimposed colour filters configured to block the other light rays directed from the optical system (10) to said pixel and corresponding to the other images.

2. The imager integrated circuit (100) according to claim 1, wherein the number of holes (105a, 105b) passing through each of both opaque layers (104a, 104b) is equal to the total number of pixels of the N subsets of pixels (102).

3. The imager integrated circuit (100) according to one of previous claims, wherein, when N = 2 and said portion (10a, 10b) of the optical system (10) corresponds to one half of the optical system (10), a distance H between the pixels (102) and a second one of both opaque layers (104b), a first of both opaque layers (104a) being provided between the pixels (102) and the second one of both opaque layers (104b), is such that $H \leq 1.5 \times p.O.n,$ with :

*p:* pitch of the pixels (102);
*O:* numerical aperture of the optical system (10);
*n:* optical index of a transparent material (106) provided between both opaque layers (104a, 104b).

4. The imager integrated circuit (100) according to claim 1, wherein the number of holes (105a) passing through a first one (104a) of both opaque layers is equal to the total number of pixels of the *N* subsets of pixels (102), and the number of holes (105b) passing through a second one (104b) of both opaque layers is equal to *(M_{pix}/N)±1*, with *M_{pix}* corresponding to said total number of pixels, said first one of both opaque layers (104a) being provided between the pixels (102) and the second one (104b) of both opaque layers.

5. The imager integrated circuit (100) according to claim 4, wherein a distance *H* between the pixels (102) and the second one (104b) of both opaque layers is such that

$$H = \frac{n.m.O.(N-1).p}{(m-1)+(m/D).(N-1).p} \, ,$$

with:

D: diameter of the optical system (10);
D/m: diameter of one of said portions (10a, 10b, 10c) of the optical system (10);
*p:* pitch of the pixels (102);
*O:* numerical aperture of the optical system (10);
*n:* optical index of a transparent material (106) provided between both opaque layers (104a, 104b).

6. The imager integrated circuit (100) according to one of previous claims, wherein at least one of the opaque layers (104a, 104b) is formed by electric interconnection lines electrically connected to the pixels (102).

7. The imager integrated circuit (100) according to one of claims 1 to 5, wherein the pixels (102) are provided between the inlet face (101) of the imager integrated circuit (100) and electric interconnection lines electrically connected to the pixels (102).

8. The imager integrated circuit (100) according to one of previous claims, wherein holes (105a, 105b) formed in the opaque layers (104a, 104b) form side by side aligned trenches or wherein the holes are provided in staggered rows.

9. The imager integrated circuit (100) according to one of previous claims, wherein each pixel (102) includes non-photosensitive electric and/or electronic elements masked by the opaque layers (104a, 104b).

10. The imager integrated circuit (100) according to one of previous claims, wherein both opaque layers (104a, 104b) are spaced apart from each other by air and/or $SiO_2$ and/or porous $SiO_2$ and/or a resin optically transparent to light rays intended to be captured by the pixels (102).

11. The imager integrated circuit (100) according to one of previous claims, wherein both opaque layers (104a, 104b) are composed of metal and/or resin and/or are covered with at least one antireflection layer.

12. The imager integrated circuit (200) according to claim 1, wherein at least one of both levels of colour filters (204) also includes portions of opaque material (206) which are configured to block, towards each pixel, part of said other light rays directed from the optical system (10) to said pixel (102) and corresponding to the other images.

13. The imager integrated circuit (200) according to one of claims 1 or 12, wherein the pixels (102) are arranged between the inlet face (101) of the imager integrated circuit (200) and electric interconnection lines electrically connected to the pixels (102).

14. The imager integrated circuit (200) according to one of claims 1, 12 or 13, wherein both levels of colour filter (202, 204) are spaced apart from each other by air and/or $SiO_2$ and/or a resin optically transparent to light rays intended to be captured by the pixels (102).

15. The imager integrated circuit (100, 200) according to one of previous claims, wherein the pixels (102) are configured to capture images in the visible and/or infrared region.

16. A stereoscopic image capture device (1000, 2000) including at least one imager integrated circuit (100, 200) according to one of previous claims and at least one optical system (10) configured to direct light rays from a scene to the imager integrated circuit (100, 200).

17. The image capture device (1000, 2000) according to claim 16, wherein the pixels (102) of the imager integrated circuit (100, 200) are configured to capture images in the infrared region, said device (1000, 2000) being a bolometer.

FIG.1

FIG.2

FIG.3

FIG.4

EP 2 515 335 B1

FIG.5

FIG.6

24

FIG.7

FIG.8

FIG.9

FIG.10A

FIG.10B

FIG.11

FIG.12

## RÉFÉRENCES CITÉES DANS LA DESCRIPTION

**Documents brevets cités dans la description**

- US 5828487 A